# EUROPEAN PATENT APPLICATION

(11) **EP 1 533 354 A1**
(43) Date of publication of application: **25.05.2005**
(21) Application number: 02792045.3
(22) Date of filing: 27.12.2002
(51) Int. Cl.: C09J 129/14, C09J 7/02, G02F 1/1345, H05K 3/32, H01B 5/02, H01B 5/14, H01R 11/01

(54) **ANISOTROPIC CONDUCTIVE FILM**

(30) Priority: 28.06.2002 JP 2002190591
(71) Applicant: Bridgestone Corporation, Tokyo 104-8340 (JP)
(72) Inventor: HIRAOKA, Hidetoshi, Kodaira-shi, Tokyo 187-0031 (JP); SAKURAI, Ryo, Kodaira-shi, Tokyo 187-0031 (JP); MIURA, Teruo, Kodaira-shi, Tokyo 187-0031 (JP); MORIMURA, Yasuhiro, Kodaira-shi, Tokyo 187-0031 (JP)
(74) Representative: Whalley, Kevin
(86) International application number: PCT/JP2002/013745
(87) International publication number: WO 2004/003097

(57) **Abstract**

An anisotropic conductive film made of an adhesive resin composition in which conductive particles are dispersed. The adhesive resin composition is a thermosetting resin composition containing base resin composed of polyacetalized resin obtained by acetalizing polyvinyl alcohol and/or modified polyacetalized resin obtained by introducing an aliphatic unsaturated group in a side chain of the polyacetalized resin, melamine-series resin, (meth) acrylate phosphate, and alkyd resin. The present invention provides an anisotropic conductive film exhibiting high adhesive strength to both ITO and SiO_{X}.

## Description

### TECHNICAL FIELD

The present invention relates to an anisotropic conductive film having conductivity only along its thickness direction.

### BACKGROUND ART

An anisotropic conductive film is made by forming an adhesive resin composition in which conductive particles are dispersed, and has conductivity along its thickness direction given by being pressed in the thickness direction. For example, the anisotropic conductive film is installed between circuits standing opposite to each other and is pressed and heated so as to electrically connect the circuits through conductive particles and to bond the circuits securely.

The anisotropic conductive film may be used for connecting a FPC (flexible printed circuit board) or a TAB (tape automated bonding) with ITO (indium tin oxide) terminals formed on a glass substrate of a liquid crystal panel. The anisotropic conductive film can be also used as an anisotropic conductive layer between various terminals so as to bond the terminals physically together and to connect the terminals electrically.

Conventional anisotropic conductive films are generally composed of an adhesive which consists mainly of an epoxy resin or a phenolic resin and a hardening agent, and conductive particles which are dispersed in the adhesive.

Among such adhesives, a one-pack type thermosetting adhesive is dominantly used as the adhesive. Attempts have made to improve the adhesive strength of the anisotropic conductive film in order to achieve a stable reliability in connection between circuits at high temperature and high humidity. The conventional anisotropic conductive films composed of an epoxy resin or phenolic resin have low adhesive strength and poor workability and are inferior in moisture resistance and heat resistance.

JP H10-338860A discloses an anisotropic conductive film composed of a thermosetting or photo-curing adhesive which consists mainly of a polyacetalized resin obtained by acetalizing polyvinyl alcohol. JP H10-338844A discloses an anisotropic conductive film composed of a thermosetting or photo-curing adhesive which consists mainly of (meth) acrylic resin obtained by polymerizing acrylic monomers and/or mathacrylic monomers.

When an anisotropic conductive film is used for connecting FPC with ITO terminals formed on a substrate of a liquid crystal panel, the anisotropic conductive film is required to bond firmly to both ITO and silica (SiO_{X}). The reasons are as follows.

The ITO terminals are formed on a glass substrate of the liquid crystal panel by applying ITO using a vapor deposition process, spattering process, ion-plating process, CVD process or the like. The substrate of the liquid crystal panel has been made of polyimide or PET (polyethylene terephthalete) for the purpose of reducing the weight or thickness of the substrate.

In this case, in order to form an ITO film with good adherence on a resin substrate made of polyimide, PET or the like, the whole surface of the substrate is coated with a SiO_{X} (SiO₂) layer before the ITO is applied thereon, and thus the ITO layer is to be formed on the SiO_{X} layer. The ITO layer is etched to remove ITO with leaving ITO corresponding to terminal portions so as to form the ITO terminals. In this manner, the substrate having ITO terminals formed on the SiO_{X} layer is produced. The anisotropic conductive film to be used for bonding such a substrate is required to have high adhesive strength to both ITO and SiO_{X}.

However, the conventional anisotropic conductive film does not exhibit high adhesive strength to both ITO and SiO_{X}. Therefore, it has been desired to be improved in its adhesiveness.

### DISCLOSURE OF THE INVENTION

An anisotropic conductive film of the present invention is an anisotropic conductive film made by forming an adhesive resin composition in which conductive particles are dispersed, wherein the adhesive resin composition is a thermosetting resin composition or a photo-curing resin composition containing base resin composed of polyacetalized resin obtained by acetalizing polyvinyl alcohol and/or modified polyacetalized resin obtained by introducing an aliphatic unsaturated group in a side chain of the polyacetalized resin, melamine-series resin, (meth)acrylate phosphate, and alkyd resin.

### DETAILED DESCRIPTION

An anisotropic conductive film of the present invention has high adhesive strength to both ITO and SiO_{X}.

Melamine-series resin improves the adhesion of the anisotropic conductive film to a resin substrate, and the adhesiveness to both ITO and SiO_{X}. An anisotropic conductive film containing melamine-series resin, (meth)acrylate phosphate and alkyd resin has significantly high adhesiveness. The (meth)acrylate phosphate significantly improve the adhesiveness of the anisotropic conductive film to SiO_{X}.

The anisotropic conductive film of the present invention has the following advantages:
1) The anisotropic conductive film has good moisture and heat resistance, so that the film effectively exhibits good anisotropic conductive properties even after it held at a high temperature and high humidity for a long period of time.
2) The anisotropic conductive film has good repairability.
3) The anisotropic conductive film has high transparency.
4) The anisotropic conductive film exhibits more stable and higher adhesiveness than conventional ones.
5) The anisotropic conductive film has a good light-transmittance when the film is made from transparent polymers, so that the film can provide good workability in positioning electrodes.
6) Although the conventional anisotropic conductive films of epoxy type or the like need to be heated to 150°C or higher for exhibiting its curing-bonding ability, the anisotropic conductive film of the present invention exhibit its curing-bonding ability at a temperature of 130°C or less, particularly 100°C or less. When the film is of an ultraviolet-curing (UV-curing) type, the anisotropic conductive film exhibits its curing-bonding ability at a still lower temperature.
7) Since the conventional anisotropic conductive films of epoxy type and phenolic type have poor sticking property, it is hard to stick the film to the electrodes temporarily and the film easily separates therefrom so that the film provides poor workability. The anisotropic conductive film of the present invention has enough high sticking property to stick to the electrodes temporarily and thus provides good workability.

The base resin of adhesive resin composition of the anisotropic conductive film of the present invention is polyacetalized resin obtained by acetalizing polyvinyl alcohol and/or modified polyacetalized resin obtained by introducing an aliphatic unsaturated group in a side chain of the polyacetalized resin.

The polyacetalized resin preferably contains acetal groups at 30 mole % or more. When the content of the acetal groups is less than 30 mole %, the anisotropic conductive film may be lowered in moisture resistance. Examples of the polyacetalized resin are polyvinyl formal, polyvinyl butyral and the like. Polyvinyl butyral is especially preferable as the polyacetalized resin. Commercially available resins may also be used as the polyacetalized resin. As the polyacetalized resin, "Denka PVB 3000-1" and "Denka PVB 2000-L" available from Denki Kagaku Kogyo Co. Ltd. may be used.

As the modified polyacetalized resin, modified polyvinyl butyral is preferable.

The polyvinyl butyral resin is composed of a vinyl butyral unit A, a vinyl alcohol unit B, and vinyl acetate unit C as shown in the following equation (1). The aliphatic unsaturated group may be introduced in a side chain of any of the units A, B, C. Polyvinyl butyral resin in which the aliphatic unsaturated group is introduced into a side chain of the polyvinyl alcohol unit B is preferable. Examples of the aliphatic unsaturated group are vinyl groups, allyl groups, methacryl groups and the like.

Introduction of the aliphatic unsaturated groups into the side chain of the polyvinyl alcohol unit B may be conducted by acid-modifying side chain hydroxyl groups. Examples of acid used for the acid modification are acrylic acid, methacrylic acid, stearyl acid, maleic acid, phthalic acid, and the like. By the acid modification, aliphatic unsaturated joint can be introduced as shown in the following equation (2).

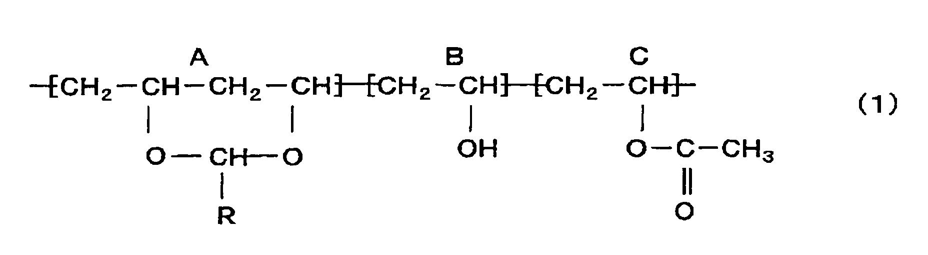

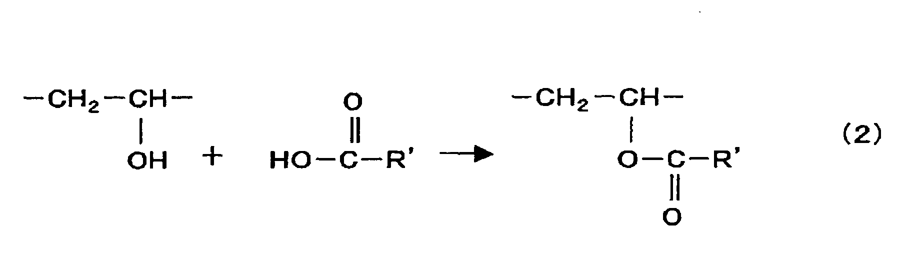

In the above equations, "R" represents a hydrogen atom or an alkyl group. "R'" represents an aliphatic unsaturated group such as alkenyl group or a group containing the same.

In the polyvinyl butyral resin as shown by the equation (1), the content of the vinyl alcohol unit B is preferably 3-70 mole %, more preferably 5-50 mole %, especially preferably 5-30 mole %. When the content of the vinyl alcohol unit B in the polyvinyl butyral resin is less than 3 mole %, the reaction during acid modification may be poor. When the content of the vinyl alcohol unit B in the polyvinyl butyral resin is higher than 70 mole %, the heat resistance and moisture resistance may be poor.

To improve the adhesiveness of the anisotropic conductive film, melamine-series resin, (meth)acrylate phosphate, or alkyd resin is mixed to the adhesive resin composition.

The melamine-series resin may be one or more among melamine resins, butylated melamine resins including isobutylated melamine resin, n-butylated melamine resin and the like, methylated melamine resins, and the like. The content of the melamine-series resin is preferably 1-200 parts by weight, particularly 1-100 parts by weight per 100 parts by weight of the base resin. The melamine-series resin less than 1 parts by weight per 100 parts by weight of the base resin does not give an adequate effect of improving the adhesiveness, while the melamine-series resin more than 200 parts by weight per 100 parts by weight of the base resin results in reduced reliability of conductivity.

As the (meth)acrylate phosphate, acrylate phosphate and/or methacrylate phosphate are used. (Meth) acrylate is a general term of acrylate and methacrylate. The acrylate phosphate and the methacrylate phosphate may be one or more among acid phosphoxy ethyl (meth)acrylate, acid phosphoxy propyl-(meth)acrylate, 2-methacryloyloxyethyl acid phosphate, diphenyl-2-methacryloyloxyethyl phosphate and the like. The content of the phosphate compound is preferably 0.1-10 parts by weight, particularly 0.5-2 parts by weight, per 100 parts by weight of the base resin. The phosphate compound less than 0.1 parts by weight per 100 parts by weight of the base resin does not give an adequate effect of improving the adhesiveness, while the phosphate compound more than 10 parts by weight per 100 parts by weight of the base resin results in reduced reliability of conductivity.

Though the alkyd resin may be pure alkyd resin or modified alkyd resin, the alkyd resin is preferably of oilfree, short oil, or medium oil. The content of the alkyd resin is preferably 0.01-10 parts by weight, particularly 0.5-5 parts by weight, per 100 parts by weight of the base resin. The alkyd resin less than 0.01 parts by weight per 100 parts by weight of the base resin does not give an adequate effect of improving the adhesiveness by being used together with the melamine-series resin, while the alkyd resin more than 10 parts by weight per 100 parts by weight of the base resin results in reduced reliability of conductivity.

In order to obtain an adequate effect of improving the adhesiveness by using the melamine-series resin, (meth)acrylate phosphate, and the alkyd resin together, it is preferable that the compounding ratios of the melamine-series resin, (meth)acrylate phosphate, and the alkyd resin = 1:0.01-10:0.01-10 (weight ratio).

To the resin composition according to the present invention, urea-series resin is preferably added in order to prevent the adhesive layer from catching bubbles, thereby ensuring the provision of superior conductivity and adhesive strength. The urea-series resin may be urea resin, butylated urea resin and the like. For the same purpose as above, phenol resin, butylated benzoguanamine resin, epoxy resin, and the like also may be added to the resin composition according to the present invention.

The content of the resin for preventing inclusion of bubbles, such as the urea-series resin, is preferably 0.01-10 parts by weight, particularly 0.5-5 parts by weight per 100 parts by weight of the base resin. The resin for preventing inclusion of bubbles less than 0.01 parts by weight per 100 parts by weight of the base resin does not give an adequate effect of preventing inclusion of bubbles, while the resin for preventing inclusion of bubbles more than 10 parts by weight per 100 parts by weight of the base resin deteriorates the conductivity.

In the present invention, in order to improve or control the characteristics (mechanical strength, adhesiveness, optical properties, heat resistance, moisture resistance, weatherability, crosslinking rate, etc.) of the anisotropic conductive film, a reactive compound (monomer) having an acryloxy group, methacryloxy group or epoxy group may be added to the resin composition. The reactive compound may be derivatives of acrylic acids or methacrylic acids, for example as the most commonly used reactive compounds, the ester and the amide thereof. Examples of ester residues of (meth) acrylic acids ester include alkyl groups such as methyl, ethyl, dodecyl, stearyl and lauryl, cycrohexyl groups, tetrahydrofurfuryl groups, aminoethyl groups, 2-hydroxyethyl groups, 3-hydroxypropyl groups, 3-chloro-2-hydroxypropyl groups. The (meth)acrylic acid ester may be ester of (meth) acrylic acid and multifunctional alcohol. Examples of the multifunctional alcohol include ethylene glycol, triethylen glycol, polypropylene glycol, polyethylene glycol, trimethylolpropane, and pentaerythritol. The (meth)acrylic acid amide may be diacetone acrylamide. The (meth)acrylic acid ester as multifunctional crosslinking agent may be the acrylic or methacrylic ester such as trimethylolpropane, pentaerythritol or glycerine. Examples of the reactive compound containing epoxy group include triglycidyl tris(2-hydroxy ethyl)isocyanurate, neopentyl glycol diglycidyl ether, 1,6-hexanediol diglycidyl ether, allyl glycidyl ether, 2-ethylhexyl grycidyl ether, phenyl glycidyl ether, phenol (EO) 5 glycidyl ether, p-t-butylphenyl grycidyl ether, diglycidyl ester adipate, diglycidyl ester phthalate, glycidyl methacrylate, and butyl grycidyl ether. Further, alloyed polymers containing epoxy groups may be used as the reactive compound.

One alone or a mixture including more than two of these reactive compounds is added preferably in an amount of 0.5-80 parts by weight, more preferably 0.5-70 parts by weight per 100 parts by weight of the base resin. The reactive compound more than 80 parts by weight per 100 parts by weight of the base resin will result in poor workability in preparing the adhesive or result in poor formability in forming the layer of the adhesive.

In order to enhance thermosetting ability of the resin composition, an organic peroxide is added as a hardening agent to the adhesive resin composition. The organic peroxide may be any of organic peroxides capable of degrading and generating radicals at a temperature of 70°C or more. It is preferable that the ten hours half-life temperature of the organic peroxide is 50°C or more. The organic peroxide is selected to be used in consideration of deposition temperature, preparation conditions, hardening (laminating) temperature, heat resistance of the object to be bonded, and storage stability.

Examples of the organic peroxide include 2,5-dimethylhexane-2,5-dihydroperoxide, 2,5-dimethyl-2,5-di(t-butylperoxy)hexyne 3, di-t-butylperoxide, t-butylcumylperoxide, 2,5-dimethyl-2,5-di(t-butylperoxy)hexane, dicumylperoxide, α-α'-bis(t-butylperoxyisopropyl)benzene, n-butyl-4,4'-bis-(t-butylperoxy)valerate, 1,1-bis(t-butylperoxy)cychlohexane, 1,1-bis(t-butylperoxy)-3,3,5-trimethylcyclohexane, t-butylperoxybenzoate, benzoylperoxide, t-butylperoxyacetate, methylethylketoneperoxide, 2,5-dimethylhexyl-2,5-bisperoxybenzoate, butylhydroperoxide, p-menthanehydroperoxide, p-chlorobezoylperoxide, hydroxyheptylperoxide, chlorohexanoneperoxide, octanoylperoxide, decanoylperoxide, lauroylperoxide, cumylperoxyoctoate, succinic acid peroxide, acetylperoxide, t-butylperoxy(2-ethylhexanoate), m-toluoylperoxide, t-butylperoxyisobutylate, 2,4-dichlorobenzoylperoxide.

Either these organic peroxides may be used alone or in combination.

The content of the organic peroxide is preferably 0.1-10 parts by weight per 100 parts by weight of the base resin.

In order to enhance photo-curing ability of the resin composition, a photosensitizer which generates radicals in response to light is added to the adhesive resin composition. As the photosensitizer (photopolymerization initiator), radical-photopolymerization initiators are preferably used. Examples of a hydrogen-pulling type initiator as one of the radical-photopolymerizationinitiators include benzophenone, methyl o-benzoylbenzoate, 4-benzoyl-4'-methyldiphenylsulfide, isopropylthioxanthone, diethylthioxanthone, and ethyl 4-(diethylamino)benzoate. Examples of an intramolecular-cleaving type initiator as one of the radical-photopolymerizationinitiators are as follows. Benzoin ether, benzoylpropyl ether, benzyldimethyl ketal, and α-hydroxyalkylphenone-type initiators, such as 2-hydroxy-2-methyl-1-phenylpropane-1-one, 1-hydroxycyclohexylphenylketone, alkylphenylglyoxylate, and diethoxyacetophenone. 2-methyl-1-[4-(methylthio)phenyl]-2-morpholinopropane-1,2 -benzyl-2-dimethy lamino-1-(4-morpholinophenyl)butanone-1 as an α-hydroxyalkylphenone-type initiator. Acyl phosphine oxide and the like.

These photosensitizers may be used alone or in combination.

The content of the photosensitizer is preferably 0.1-10 parts by weight per 100 parts by weight of the base resin.

To the resin compositions of the present invention, a silane coupling agent may be added as the adhesion promoting agent. As the silane coupling agent, a single one or a mixture composed of two or more selected from the group consisting of vinyl triethoxysilane, vinyl tris(β-methoxyethoxy)silane, γ-methacryloxypropyl trimethoxysilane, vinyl triacetoxysilane, γ-glycidoxypropyl trimethoxysilane, γ-glycidoxypropyl triethoxysilane, β-(3,4-epoxycyclohexyl)ethyltrimethoxysilane, vinyl trichlorosilane, γ-mercaptopropyl trimethoxysilane, γ-aminopropyl triethoxysilane, and N-β-(aminoethyl)-γ-aminopropyl trimethoxysilane.

The content of the silane coupling agent is normally 0.01-5 parts by weight per 100 parts by weight of the base resin.

To the resin compositions of the present invention, hydrocarbon resin may be added in order to improve processing and laminating characteristics. The hydrocarbon resin can be either the natural resin or synthetic resin. As the natural hydrocarbon resin, rosin, rosin derivatives, and terpene resin may be used. Examples of the rosin are gum resin, tall oil resin and wood resin. The rosin derivative may be hydrogenated rosin, disproportionated rosin, polymerized rosin, esterified rosin and metallized rosin may be used. Examples of the terpene resin are terpene-series resins such as an α-pinene, a β-pinene and the like, and terpene phenol resins. As another natural resin, dammar, copal, and shellac may be used. The synthetic hydrocarbon resin may be petroleum resins, phenol resins or xylene resins. Examples of the petroleum resin are aliphatic petroleum resins, aromatic petroleum resins, cycloaliphatic petroleum resins, copolymer petroleum resins, hydrogenated petroleum resins, pure monomer petroleum resins and coumarone-indene resins. Examples of the phenol resin are alkylphenol resins and modified phenol resins. Examples of the xylene-series resin are xylene resins and modified xylen resins.

The content of the hydrocarbon resin is not limited, but preferably 1-200 parts by weight, more preferably 5-150 parts by weight per 100 parts by weight of the base resin.

To the resin composition according to the present invention, an age resistor, ultraviolet absorber, dye, and/or processing aid may be added in such an amount as not to interrupt the object of the present invention.

As the conductive particles, any conductive particles having good electrical conductivity may be used so that a variety of conductive particles may be used. Examples of the conductive particles are metal such as copper, silver, and nickel, alloy powder thereof, resin coated with such metal or alloy, and ceramic particles coated with such metal or alloy.

There is no specific limitations on the configuration of the conductive particles so that the particles may have any configuration such as acale-like, dendritic, granular, or pellet-like configuration.

The conductive particles are preferable to have a modulus of elasticity of from 1.0×10⁷ to 1.0×10¹⁰ Pa. The reason is as follows. That is, when an anisotropic conductive film including conductive particles which have a high modulus of elasticity is used for bonding objects such as liquid crystal films of which the base material is plastic film, breakage such as cracking of the bonded objects may occur and spring back may be caused due to elastic recovery of the particles after bonding the objects whereby the anisotropic conductive film cannot achieve stable electrical conductive properties. With using conductive particles having a modulus of elasticity within the above range, it is possible to prevent the breakage of bonded objects and to depress the spring back caused due to elastic recovery of the particles after being bonded with pressure, and it is also possible to increase contact area of the conductive particles, so that the stable conductive properties with good reliability can be achieved. Conductive particles having a modulus of elasticity less than 1.0×10⁷ Pa are easily damaged, thus deteriorating the conductive properties, and conductive particles having a modulus of elasticity more than 1.0×10¹⁰ Pa can allow the spring back to occur. The conductive particles may consist of plastic core particles which have a modulus of elasticity within the above range and a surface layer of the above metal or alloy coated thereon.

The content of conductive particles is preferably in the range from 0.1% to 15% by volume relative to the base resin.

The mean particle diameter of the conductive particles is preferably 0.1-100 µm.

As the content and the particle diameter of the conductive particles are in the range mentioned above, the conductive particles are condensed between adjacent circuits so as to make short circuit difficult, thereby giving excellent conductivity.

The anisotropic conductive film of the present invention is composed of an adhesive resin composition in which the conductive particles are dispersed. The adhesive resin composition containing the conductive particles is preferably have a melt flow rate (MFR) of from 1 to 3000, more preferably 1 to 1000, most preferably 1 to 800. The adhesive resin composition containing the conductive particles is preferably have fluidity of 10⁵ Pa•s or less at a temperature of 70°C. The components of the adhesive resin composition containing the conductive particles are preferably selected to obtain MFR and fluidity in the ranges mentioned above.

The anisotropic conductive film of the present invention is produced, for example, as follows. The adhesive resin composition is mixed homogeneously with the conductive particles and is kneaded by an extruder, rolls or the like. After that, the mixture is formed into the desired shape of a film by a production method such as calender roll method, T-die extrusion method, inflation method or the like. The adhesive resin composition and the conductive particles are dissolved and dispersed in solvent and are applied to a surface of a separator. After that the solvent is evaporated, thereby forming a film. For forming a film, embossing may be applied to the film in order to prevent blocking and facilitate pressure bonding of the film to the object to be bonded.

For bonding objects to each other with the anisotropic conductive film, for example, laminating method using hot press, a direct laminating method using an extruding machine or a calendaring machine, a hot press laminating method using a film laminator and the like can be employed.

The hardening conditions for the anisotropic conductive film of the present invention are as follows. In case of thermosetting, the hardening conditions depend on the kind of the organic peroxide to be used, but the conditions are normally from 70 to 170°C, preferably 70 to 150°C, and 10 seconds to 120 minutes, preferably 20 seconds to 60 minutes.

In case of photo-curing, many of light sources which generate lights ranging from ultraviolet region to visible region can be used. Examples of the light sources include ultra-high-pressure, high-pressure and low-pressure mercury vapor lamps, a chemical lamp, a xenon lamp, a halogen lamp, a mercury-halogen lamp, a carbon-arc lamp, an incandescent lamp, and a laser. Though the time for irradiation depends on the type of a lamp to be used and its strength of illumination so that the following range is not completely determined, the time for irradiation is on the order of tens of seconds to tens of minutes. The laminated film may be heated at 40 to 120°C and followed by irradiation of ultraviolet light in order to prompt hardening of the film.

The laminated film is preferably applied with pressure on the order of 1-4 MPa, particularly 2 to 3 MPa in the bonding direction during bonding process.

The anisotropic conductive film of the present invention is preferably have a conductivity of 10Ω or less, particularly 5Ω or less in the thickness direction of the film, and resistively of 10⁶Ω or more, particularly 10⁹Ω or more in the direction along its surface.

The anisotropic conductive film Of the present invention can be used for the same applications as conventional ones, including applications of making connections between various terminals, such as connections between FPC or TAB and ITO terminals on the glass substrate of a liquid crystal panel. In the anisotropic conductive film of the present invention, a cross-linked structure is formed within the adhesive resin composition during the hardening of the adhesive resin composition, whereby the anisotropic conductive film has good adhesiveness, particularly good adhesion to the metal, good durability, and high heat resistance.

The anisotropic conductive film of the present invention has good adhesiveness to both ITO and SiO_{X}, significantly good adhesiveness particularly to SiO_{X}, so that the film can be suitably used for connection between these terminals.

Hereinafter, examples and comparative examples are referred.

### EXAMPLES 1-4 AND COMPARATIVE EXAMPLES 1-4

25 weight % toluene solution of polyvinyl butyral ("Denka PVB 3000-1" available from Denki Kagaku Kogyo Co. Ltd.,) was prepared and the additives shown in Table 1 were added in the solution at amounts shown in Table 1. The solution thus prepared was applied on a separator made of polyethyleneterephthalate by a bar coater and solvent was evaporated, thereby obtaining a film (sample) having a width of 5 mm and a thickness of 15 µm.

The separator was peeled off from the obtained sample. The sample was disposed between a substrate made of PET resin having ITO terminals formed thereon via a SiO_{X} layer and a substrate made of polyimide having copper foil patterned thereon and was positioned by using a monitor, thereby bonding these substrates. In case of thermosetting (Examples 1, 3 and Comparative Examples 1, 3, 4), the laminated substrates were heated at 130°C for 20 seconds and pressed at 3 MPa. In case of photo-curing (Examples 2, 4 and Comparative Example 2), the laminated substrates were irradiated with light by a halogen lamp for 30 seconds instead of heating and pressed at 3 MPa. As for the bonded samples, the adhesive strength was measured by a tensile strength tester in 90° peel strength test (50 mm/min) and the electrical resistance through the thickness of the film was measured by a digital multimeter. The results of the measurement are shown in Table 1.

Adhesive resin compositions of Examples 1, 2 were prepared by adding acrylate phosphate to the adhesive resin compositions of Comparative Examples 1, 2, respectively. Adhesive resin compositions of Examples 3, 4 were prepared by adding methacrylate phosphate to the adhesive resin compositions of Comparative Examples 1, 2, respectively. An adhesive resin composition of Comparative Example 3 was the same as the adhesive resin composition of Comparative Example 1 but not containing alkyd resin. An adhesive resin composition of Comparative Example 4 was the same as the adhesive resin composition of Comparative Example 1 but not containing melamine-series resin and containing alkyd resin twice the amount in Comparative Example 1.

### EXAMPLES 5-12

A film was obtained in the same manner as Examples 1-4 but using acrylic modified polyvinyl butyral (Examples 5-8) or methacrylic modified polyvinyl butyral (Examples 9-12) instead of the polyvinyl butyral. Then, the film was used for bonding substrates. Examples 5, 9 correspond to Example 1, Examples 6, 10 correspond to Example 2, Examples 7, 11 correspond to Example 3, and Examples 8, 12 correspond to Example 4. Results of measurements, conducted in the same manner as Examples 1-4, are shown in Table 1.

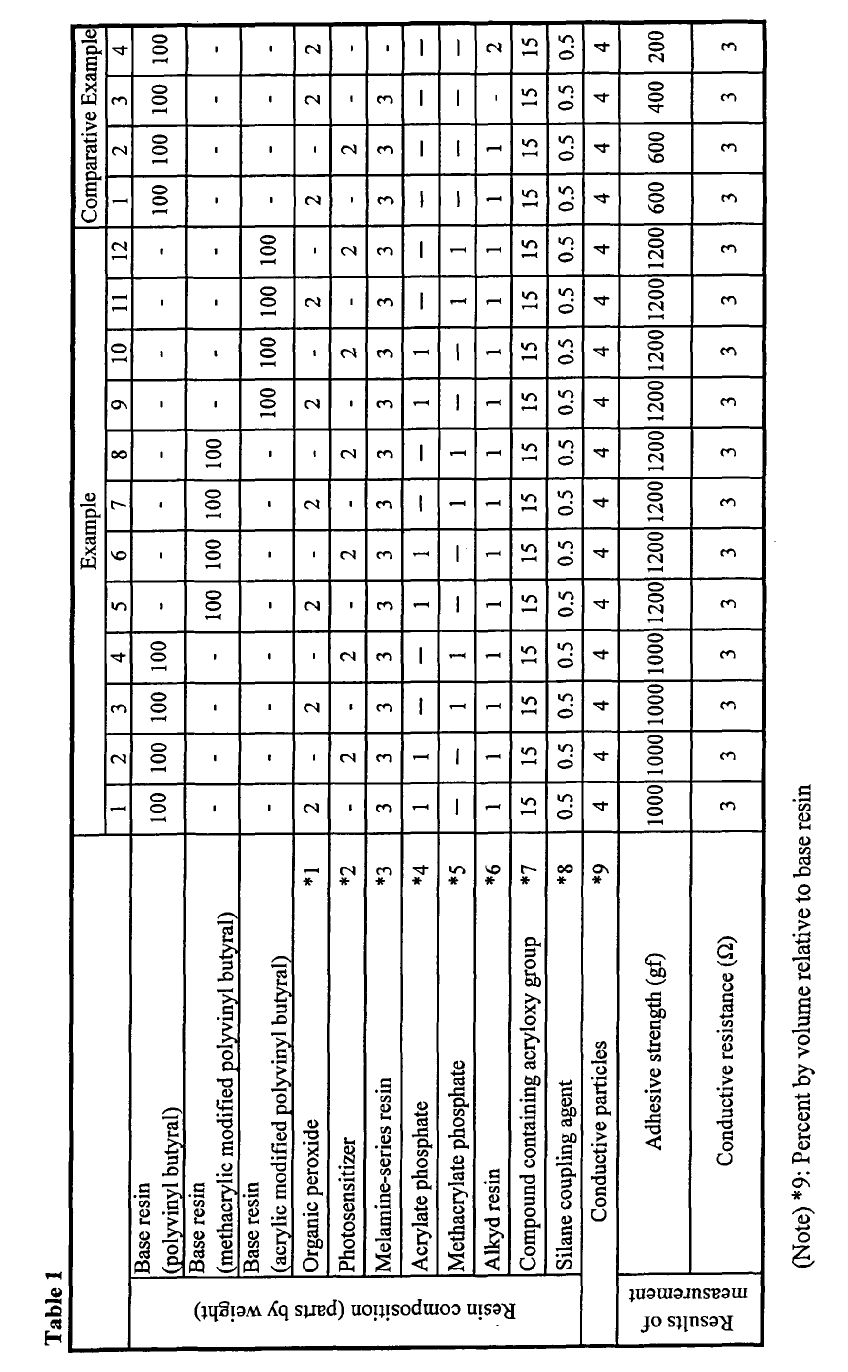

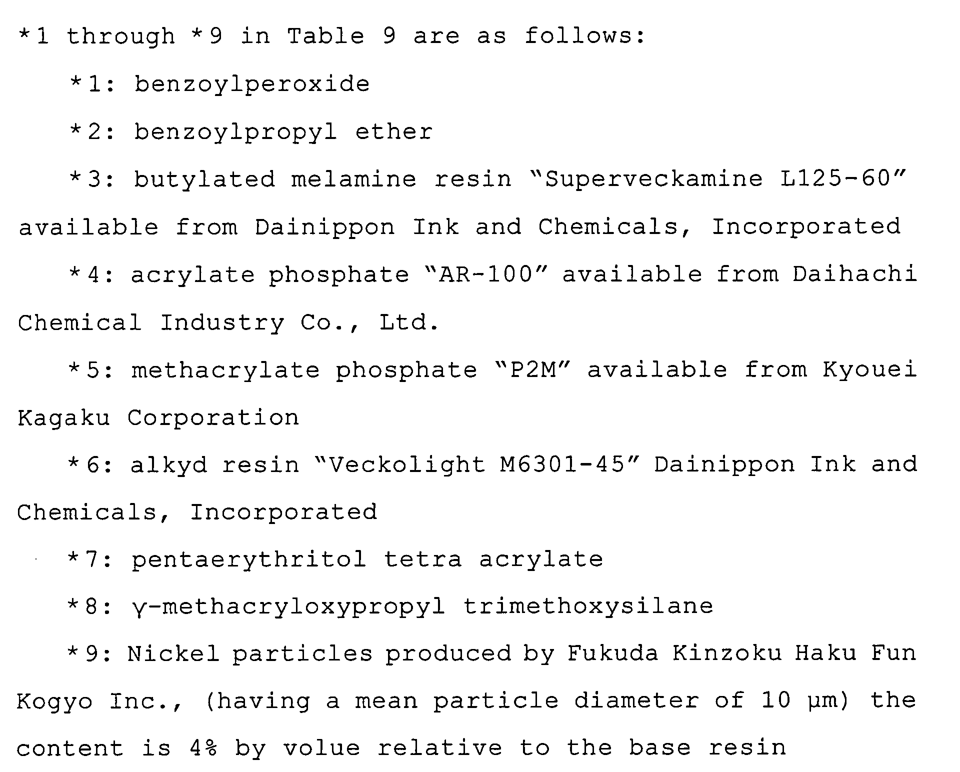

It is apparent from Table 1 that the anisotropic conductive films of the present invention are remarkably excellent in adhesiveness. Examples 1-12 have adhesive strength enough higher than the adhesive strength of Comparative Examples 1, 2. Examples 5-12 using modified polyvinyl butyral have more excellent adhesiveness than that of Examples 1-4 using polyvinyl butyral. Comparative Examples 3, 4 are remarkably poor in adhesiveness even compared to Comparative Examples 1, 2.

### Industrial Applicability

As described above, the present invention can provide an anisotropic conductive film exhibiting high adhesive strength to both ITO and SiO_{X}.

## Claims

1. An anisotropic conductive film made by forming an adhesive resin composition in which conductive particles are dispersed, wherein
the adhesive resin composition is a thermosetting resin composition or a photo-curing resin composition containing base resin composed of polyacetalized resin obtained by acetalizing polyvinyl alcohol and/or modified polyacetalized resin obtained by introducing an aliphatic unsaturated group in a side chain of the polyacetalized resin, melamine-series resin, (meth)acrylate phosphate, and alkyd resin.

2. An anisotropic conductive film as claimed in claim 1, wherein the resin composition contains 1-200 parts by weight of the melamine-series resin per 100 parts by weight of the base resin.

3. An anisotropic conductive film as claimed in claim 1, wherein the resin composition contains 0.1-10 parts by weight of the (meth) acrylate phosphate per 100 parts by weight of the base resin.

4. An anisotropic conductive film as claimed in claim 1, wherein the resin composition contains 0.01-10 parts by weight of the alkyd resin per 100 parts by weight of the base resin.

5. An anisotropic conductive film as claimed in claim 1, wherein the compounding ratios of the melamine-series resin, the (meth) acrylate phosphate, and the alkyd resin are set to satisfy melamine-series resin, (meth)acrylate phosphate, and alkyd resin = 1:0.01-10:0.01-10 (weight ratio).

6. An anisotropic conductive film as claimed in claim 1, wherein the resin composition contains 0.1-10 parts by weight of the organic peroxide or photosensitizer per 100 parts by weight of the base resin.

7. An anisotropic conductive film as claimed in claim 1, wherein the resin composition contains 0.5-80 parts by weight of at least one reactive compound selected from a group consisting of a compound containing an acryloxy group, a compound containing a methacryloxy group, and a compound containing an epoxy group par 100 parts by weight of the base resin.

8. An anisotropic conductive film as claimed in claim 1, wherein the resin composition contains 0.01-5 parts by weight of a silane coupling agent per 100 parts by weight of the base resin.

9. An anisotropic conductive film as claimed in claim 1, wherein the resin composition contains 1-200 parts by weight of hydrocarbon resin per 100 parts by weight of the base resin.

10. An anisotropic conductive film as claimed in claim 1, wherein the content of the conductive particles is in the range from 0.1% to 15% by volume relative to the base resin.

11. An anisotropic conductive film as claimed in claim 1, wherein the mean particle diameter of the conductive particles is in the range of from 0.1 to 100 µm.

12. An anisotropic conductive film as claimed in claim 1, wherein the polyacetalized resin contains acetal groups at 30 mole % or more.

13. An anisotropic conductive film as claimed in claim 12, wherein the polyacetalized resin is polyvinyl butyral resin.

14. An anisotropic conductive film as claimed in claim 13, wherein the polyvinyl butyral resin is composed of a vinyl butyral unit A, a vinyl alcohol unit B, and vinyl acetate unit C as shown in the following equation (1) and the retio of the vinyl alcohol unit B in the polyvinyl butyral resin is in the range of from 3 to 70 mole % 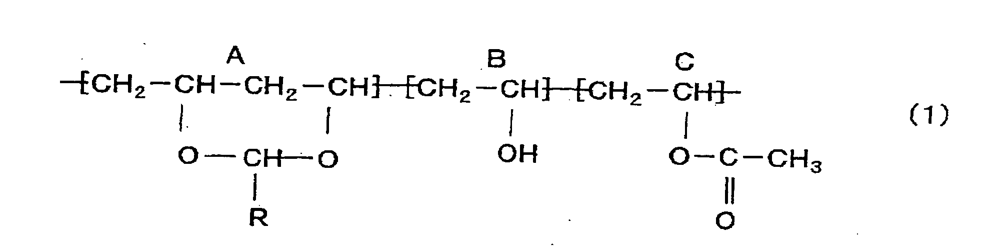 (wherein, "R" represents a hydrogen atom or an alkyl group).

15. An anisotropic conductive film as claimed in claim 12, wherein the modified polyacetalized resin is modified polyvinyl butyral resin.

16. An anisotropic conductive film as claimed in claim 15, wherein the polyvinyl butyral resin of the modified polyvinyl butyral resin is composed of a vinyl butyral unit A, a vinyl alcohol unit B, and vinyl acetate unit C as shown in the following equation (1) and the ratio of the vinyl alcohol unit B in the polyvinyl butyral resin is in the range of from 3 to 70 mole % 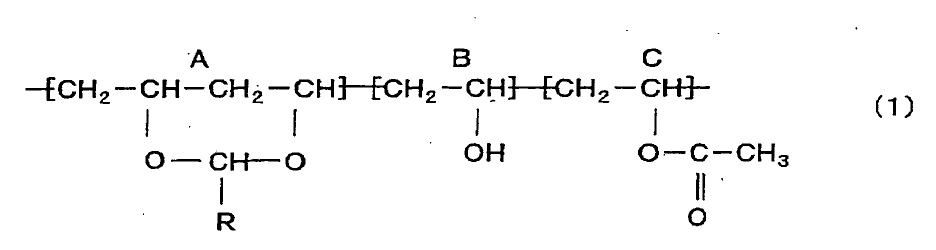 (wherein, "R" represents a hydrogen atom or an alkyl group).

17. An anisotropic conductive film as claimed in claim 16, wherein introduction of the aliphatic unsaturated group into the side chain of the polyvinyl alcohol unit B is conducted by acid-modifying side chain hydroxyl groups with acrylic acid, methacrylic acid, stearyl acid, maleic acid, or phthalic acid.

18. An anisotropic conductive film as claimed in claim 1, wherein the anisotropic conductive film is employed for bonding ITO terminals formed on a resin substrate via a SiOₓ layer.
